Europäisches Patentamt

European Patent Office

Office européen des brevets

(19)

(11) **EP 1 173 774 B1**

(12)        **EUROPÄISCHE PATENTSCHRIFT**

(45) Veröffentlichungstag und Bekanntmachung des
Hinweises auf die Patenterteilung:
**29.06.2005   Patentblatt 2005/26**

(21) Anmeldenummer: **00926960.6**

(22) Anmeldetag: **15.04.2000**

(51) Int Cl.⁷: $G01R\ 15/18$

(86) Internationale Anmeldenummer:
**PCT/EP2000/003444**

(87) Internationale Veröffentlichungsnummer:
**WO 2000/067040 (09.11.2000 Gazette 2000/45)**

(54) **STROMSENSOR NACH DEM KOMPENSATIONSPRINZIP**

CURRENT SENSOR WORKING IN ACCORDANCE WITH THE COMPENSATION PRINCIPLE

CAPTEUR DE COURANT FONCTIONNANT SELON LE PRINCIPE DE LA COMPENSATION

(84) Benannte Vertragsstaaten:
**CH DE FR GB IT LI SE**

(30) Priorität: **29.04.1999   DE 19919602**

(43) Veröffentlichungstag der Anmeldung:
**23.01.2002   Patentblatt 2002/04**

(73) Patentinhaber:
• **Vacuumschmelze GmbH
63450 Hanau (DE)**
• **SEMIKRON Elektronik GmbH
90431 Nürnberg (DE)**

(72) Erfinder:
• **LENHARD, Friedrich
D-63452 Hanau (DE)**
• **SCHÄFER, Stefan
D-55452 Rümmelsheim (DE)**
• **MOURICK, Paul
D-90766 Fürth (DE)**

(74) Vertreter: **Schmuckermaier, Bernhard et al
PAe Westphal, Mussgnug & Partner,
Mozartstrasse 8
80336 München (DE)**

(56) Entgegenhaltungen:
**EP-A- 0 742 440            DE-A- 19 642 472
DE-A- 19 705 767**

• **SUZUKI Y ET AL: "ANALYSIS OF A ZERO-FLUX
TYPE CURRENT SENSOR" IEEE
TRANSACTIONS ON MAGNETICS,US,IEEE INC.
NEW YORK, Bd. 29, Nr. 6, 1. November 1993
(1993-11-01), Seiten 3183-3185, XP000432425
ISSN: 0018-9464**

Bemerkungen:
Die Akte enthält technische Angaben, die nach dem
Eingang der Anmeldung eingereicht wurden und die
nicht in dieser Patentschrift enthalten sind.

**Beschreibung**

Die Erfindung betrifft einen Stromsensor nach dem Kompensationsprinzip mit einer vom zu messenden Strom durchflossenen Primärwicklung, die ein Magnetfeld erzeugt, das durch einen in einer Sekundärwicklung fließenden Kompensationsstrom kompensierbar ist, und mit vom Magnetfeld beeinflußten Sensormitteln, denen eine Treiberschaltung nachgeschaltet ist, die die in Reihe mit einem Abschlußwiderstand geschaltete Sekundärwicklung mit einem pulsweitenmodulierten Kompensationssignal beaufschlagt.

Ein derartiger Stromsensor ist aus der DE-A-197 05 767 bekannt. Der bekannte Stromsensor weist einen Komparator auf, der an einem Komparatoreingang mit dem vom Sensormittel gelieferten Meßsignal und an einem anderen Komparatoreingang mit einer von einem Spannungsgenerator erzeugten Sägezahnspannung beaufschlagt ist. Der Komparator steuert zwei Gegentaktendstufen an, zwischen denen in Brückenschaltung der Abschlußwiderstand sowie die Sekundärwicklung geschaltet sind.

Aus der DE-OS-196 42 472 ist ein Stromsensor bekannt, der zur Verringerung des Energiebedarfs für den Kompensationsstrom und zur Reduzierung der Verluste bei einem Betrieb mit überhöhter Versorgungsspannung einen schaltenden Verstärker verwendet, der mit einem pulsenden Ansteuersignal angesteuert wird, das ein in Abhängigkeit vom Meßwert gesteuertes Tastverhältnis besitzt.

Die EP-0 742 440 offenbart eine Vorrichtung zur Kompensationsstromwandlung, bei der ein getakteter Verstärker zur Erzeugung des Kompensationsstromes eingesetzt wird, dem eine Reglerstufe vorgeschaltet ist. Der pulsweitenmodulierte Takt wird dabei aus einem Oszillator mit fester Frequenz abgeleitet.

Ein Nachteil bekannter Stromsensoren ist, daß aufgrund des Frequenzgangs der Treiberschaltung nur Primärströme bis zu einer bestimmten oberen Grenzfrequenz erfaßbar sind. Denn bei Frequenzen des Primärstroms oberhalb der Grenzfrequenz kann der Stromsensor den Änderungen des Primärstroms nicht länger folgen, so daß über den Abschlußwiderstand keine Spannung abfällt, obwohl ein Primärstrom durch die Primärwicklung fließt.

Ausgehend von diesem Stand der Technik liegt der Erfindung die Aufgabe zugrunde, einen Stromsensor zu schaffen, der auch bei hohen Primärstromfrequenzen einsetzbar ist.

Diese Aufgabe wird durch einen Stromsensor gemäß Patentanspruch 1 gelöst. Ausgestaltungen und Weiterbildungen des Erfindungsgedankens sind Gegenstand von Unteransprüchen.

Dabei weist das pulsweitmodulierte Kompensationssignal Taktfrequenzen oberhalb einer Wandlergrenzfrequenz auf. Der Frequenzgang der Treiberschaltung gewährleistet bei vorhandenem zu messendem Strom einen messbaren Spannungsabfall über dem Abschlußwiderstand. Darüber hinaus ist eine Tiefpaßfilteranordnung zur Glättung des pulsweitenmodulierten Kompensationsstromes vorgesehen, die der Treiberschaltung nachgeschaltet ist, Induktivitäten und Kapazitäten umfaßt, eine Filtergrenzfrequenz oberhalb der Wandergrenzfrequenz und unterhalb der Taktfrequenz der Treiberschaltung besitzt sowie eine Resonanzüberhöhung aufweist, wobei die Resonanzüberhöhung der Tiefpaßfilteranordnung durch ein parallel zu Sekundärwicklung und Abschlußwiderstand geschaltetes RC-Glied gedämpft wird.

Die Erfindung nutzt somit die Tatsache aus, daß der Stromsensor bei hohen Primärstromfrequenzen als Stromwandler arbeitet. Denn bei hohen Primärstromfrequenzen wird das anregende Magnetfeld zunehmend durch die aufgrund der induzierten Gegenspannung in der Sekundärwicklung fließenden Sekundärströme kompensiert. Die aufgrund des Wandlerverhaltens durch die Sekundärwicklung fließenden Sekundärströme haben ebenfalls einen Spannungsabfall am Abschlußwiderstand zur Folge. Die am Abschlußwiderstand aufgrund des Wandlerverhaltens auftretende Spannung macht sich dabei umso stärker bemerkbar je höher die Frequenz des Primärstroms ist, um oberhalb einer Wandlergrenzfrequenz sich einem oberen Grenzwert anzunähern. Damit nun der Stromsensor gemäß der Erfindung unabhängig von der Primärstromfrequenz einsetzbar ist, ist dafür zu sorgen, daß auch im Frequenzbereich zwischen Wandlerverhalten und Sensorverhalten keine Lücke entsteht, in der die Spannung am Abschlußwiderstand wesentlich abfällt. Dies wird insbesondere dadurch erreicht, daß die Taktfrequenzen des pulsweitenmodulierten Kompensationssignals oberhalb der Wandlergrenzfrequenz liegen und daß der Frequenzgang der Treiberschaltung, insbesondere deren obere Grenzfrequenz, auch im Frequenzbereich zwischen Sensorverhalten und Wandlerverhalten einen meßbaren Spannungsabfall über dem Abschlußwiderstand gewährleistet. Beide Maßnahmen zusammen stellen sicher, daß auch in einem Übergangsbereich zwischen Sensorverhalten und Wandlerverhalten ein meßbarer Spannungsabfall über dem Abschlußwiderstand auftritt.

Weitere vorteilhafte Ausgestaltungen und Ausführungsbeispiele sind Gegenstand der abhängigen Ansprüche.

Nachfolgend werden Ausführungsbeispiele der Erfindung im einzelnen anhand der beigefügten Zeichnung erläutert. Es zeigen:

Figur 1     die Schaltung eines nicht unter die Erfindung fallenden Stromsensors mit zwei Gegentaktendstufen, zwischen denen ein Abschlußwiderstand und die Sekundärwicklung in Reihe mit Tiefpaßfiltern in Brückenschaltung angeordnet sind;

Figur 2     ein Diagramm, das den Frequenzgang der über den Abschlußwiderstand abfallenden Spannung in Abhängigkeit von der Primärstromfrequenz zeigt;

Figur 3    ein Ersatzschaltbild für die Brückenschaltung aus Figur 1;

Figur 4    ein Diagramm, das den Frequenzgang der Spannungsamplitude und der Phase bei dem Ersatzschaltbild aus Figur 3 darstellt;

Figur 5    eine Schaltung eines Stromsensors, bei dem die durch die Tiefpaßfilter hervorgerufene Resonanzüberhöhung durch ein RC-Glied gedämpft ist;

Figur 6    ein Diagramm, das den Frequenzgang und die Amplitude der Brückenschaltung aus Figur 5 darstellt;

Figur 7    eine schematische Darstellung, die die unterschiedliche Kopplung zwischen Primärwicklung und Sekundärspulen veranschaulicht; und

Figur 8    ein weiterer Stromsensor, bei dem Spannungsüberhöhungen zwischen den Sekundärspulen durch Begrenzungsmittel begrenzt sind.

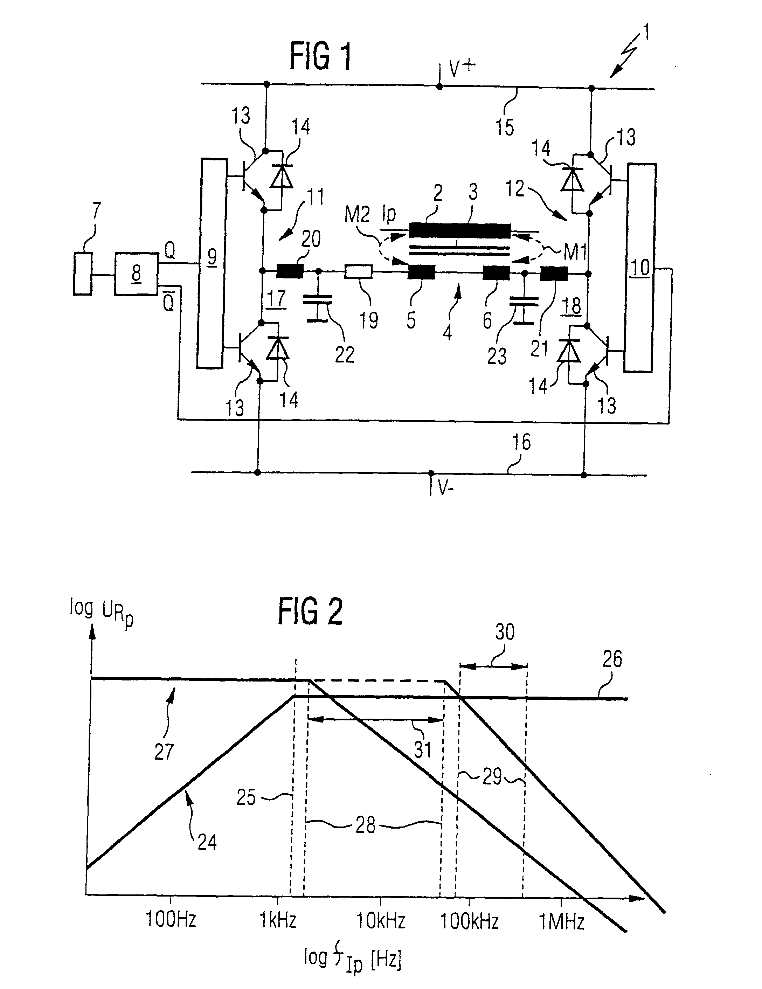

Figur 1 zeigt einen nicht unter die Erfindung fallenden Stromsensor 1 mit einer vom zu messenden Primärstrom $I_p$ durchflossenen Primärwicklung 2, die über einen Magnetkern 3 an zwei die Sekundärwicklung 4 bildende Sekundärspulen 5 und 6 gekoppelt sind. Die magnetische Kopplung zwischen der Primärwicklung 2 und den Sekundärspulen 5 und 6 ist jeweils durch die gestrichelten Pfeile M1 und M2 veranschaulicht. Der magnetische Fluß im Magnetkern 3 wird von einem Magnetfeldsensor 7 erfaßt, der einen Signalgenerator 8 zum Erzeugen von pulsweitenmodulierten Treibersignalen Q und $\overline{Q}$ beaufschlagt. Die Treibersignale Q und $\overline{Q}$ werden Endstufenschaltungen 9 und 10 zugeführt, die jeweils zwei Gegentaktendstufen 11 und 12 bildende Transistoren 13 ansteuern. Durch die Umsetzung des Meßsignals des Magnetfeldsensors 7 in die pulsweitenmodulierten Kompensationssignale, werden die Verluste in den Gegentaktendstufen 11 und 12 minimiert. Die Leistungstransistoren 13 sind jeweils von Freilaufdioden 14 überbrückt und unmittelbar an Versorgungsleitungen 15 und 16 angeschlossen. In Brückenschaltung zwischen den Gegentaktendstufen 11 und 12 sind jeweils Tiefpaßfilter 17 und 18, ein Abschlußwiderstand 19, sowie die Sekundärspulen 5 und 6 angeordnet. Die Tiefpaßfilter 17 und 18 umfassen jeweils Spulen 20 und 21 mit nachgeschaltetem, mit Masse verbundenen Kondensatoren 22 und 23.

Die Funktion des Stromsensors 1 wird nunmehr anhand Figur 2 erläutert.

Figur 2 stellt den Frequenzgang verschiedener am Abschlußwiderstand 19 abfallender Spannungskomponenten in Abhängigkeit von der Frequenz des Primärstroms $I_p$ dar. Eine Wandlerkennlinie 24 stellt die Frequenzabhängigkeit derjenigen Spannungskomponente dar, die aufgrund des Wandlerverhaltens des Stromsensors 1 am Abschlußwiderstand 19 abfällt. Da mit zunehmender Frequenz des Primärstroms $I_p$ das erregende Magnetfeld durch den aufgrund der induzierten Gegenspannung in den Sekundärspulen 5 und 6 fließenden Sekundärstrom immer stärker kompensiert wird, fällt am Abschlußwiderstand 19 eine mit zunehmender Frequenz steigende Spannung ab. Wegen der mit größer werdenden Frequenz zunehmenden Kompensation des magnetischen Flusses durch den Strom in den Sekundärspulen 5 und 6 erreicht die durch das Wandlerverhalten hervorgerufene Spannungskomponente schließlich oberhalb einer Wandlergrenzfrequenz 25 eine Maximalspannung 26.

Die Sensorkennlinie 27 in Figur 2 veranschaulicht die Frequenzabhängigkeit derjenigen am Abschlußwiderstand 19 abfallenden Spannungskomponente, die durch das Sensorverhalten des Stromsensors 1 hervorgerufen wird. Bis zu einer Sensorgrenzfrequenz 28 ist diese Spannungskomponente im wesentlichen konstant, um dann oberhalb der Sensorgrenzfrequenz 28 bedingt durch den Frequenzgang der vom Signalgenerator 8, den Endstufenschaltungen 9 und 10 sowie den Gegentaktendstufen 11 und 12 gebildeten Treiberschaltung abzufallen. Damit bei jeder Frequenz des Primärstrom $I_p$ am Abschlußwiderstand 19 eine Spannung abfällt, ist es notwendig, das Auftreten einer Lücke im Übergangsbereich zwischen Wandlerverhalten und Sensorverhalten zu vermeiden. Deshalb sollen Taktfrequenzen 29 der pulsweitenmodulierten Kompensationssignale Q und $\overline{Q}$ möglichst oberhalb der Wandlergrenzfrequenz 25 liegen. Ein möglicher Bereich der Taktfrequenzen 29 ist in Figur 2 durch einen Pfeil 30 veranschaulicht. Auch die Sensorgrenzfrequenz 28 liegt vorzugsweise oberhalb der Wandlergrenzfrequenz 25. Wenn jedoch ein Einbruch der am Abschlußwiderstand 19 abfallenden Meßspannung in Kauf genommen wird, kann die Sensorgrenzfrequenz 28 auch unterhalb der Wandlergrenzfrequenz 25 liegen. Es ist jedoch darauf zu achten, daß die Sensorgrenzfrequenz 28 nicht so niedrig ist, daß die Meßspannung am Abschlußwiderstand 19 derart stark einbricht, daß zwischen Wandlerverhalten und Sensorverhalten eine Lücke im Frequenzgang der Meßspannung entsteht.

Üblicherweise wird die am Abschlußwiderstand 19 abfallende Meßspannung mit Hilfe eines an den beiden Enden des Abschlußwiderstands 19 angeschlossenen Differenzverstärkers gemessen. Wenn nun der Frequenzgang der Treiberschaltung, die von dem Signalgenerator 8, den Endstufenschaltungen 9 und 10 sowie den Gegentaktendstufen 11 und 12 gebildet ist, eine Sensorgrenzfrequenz 28 aufweist, die über den Taktfrequenzen 29 liegt, und wenn die Tiefpaßfilter 17 und 18 nicht vorhanden sind, liegt an den Eingängen des Differenzverstärkers über dem Abschlußwiderstand 19 eine Gleichtaktspannung mit einem Spannungshub gleich der Spannungsdifferenz der Versorgungsspannungen und einer Frequenz gleich der Taktfrequenz 29 an. Typischerweise würde dann der Differenzverstärker über dem Abschlußwiderstand 19 mit einer Gleichtaktspannung von +/- 15 Volt bei einer Frequenz von 400 kHz belastet. Die Gleichtaktunterdrückung üblicher Operationsverstärker ist mit einer derartigen Gleichtaktbelastung überfordert.

Es ist deshalb zweckmäßig, die Sensorgrenzfrequenz 28 auf Werte unterhalb der Taktfrequenz 29 zu legen. Somit ergibt sich der in Figur 2 durch einen Pfeil 31 angedeutete bevorzugte Bereich für die Sensorgrenzfrequenz 28.

Die Sensorgrenzfrequenz 28 läßt sich beispielsweise durch die in Figur 1 dargestellten Tiefpaßfilter 17 und 18 wirksam zu kleinen Werten hin verschieben. Dies wird in der Schaltung nach Figur 1 durch die Tiefpaßfilter 17 und 18 mit den Spulen 20 und 21 sowie den Kondensatoren 22 und 23 bewerkstelligt. Typische Werte für die Induktivitäten der Spulen 20 und 21 und für die Kapazitäten der Kondensatoren 22 und 23 sind 68 bis 100 μH und 100 nF. Ein Nachteil der Schaltung aus Figur 1 ist, daß die verwendeten Tiefpaßfilter 17 und 18 eine ausgeprägte Phasenverschiebung aufweisen. Dadurch kann eine nicht erwünschte Mitkoppelung über den Kreis Magnetfeldsensor 7, Signalgenerator 8, Endstufenschaltung 9 und 10, Gegentaktendstufe 11 und 12, Sekundärwicklung 4, Magnetfeldsensor 7 entstehen, weshalb die Schaltung frei mit einer Frequenz, die der Resonanzfrequenz der Tiefpaßfilter 17 und 18 entspricht, schwingen kann.

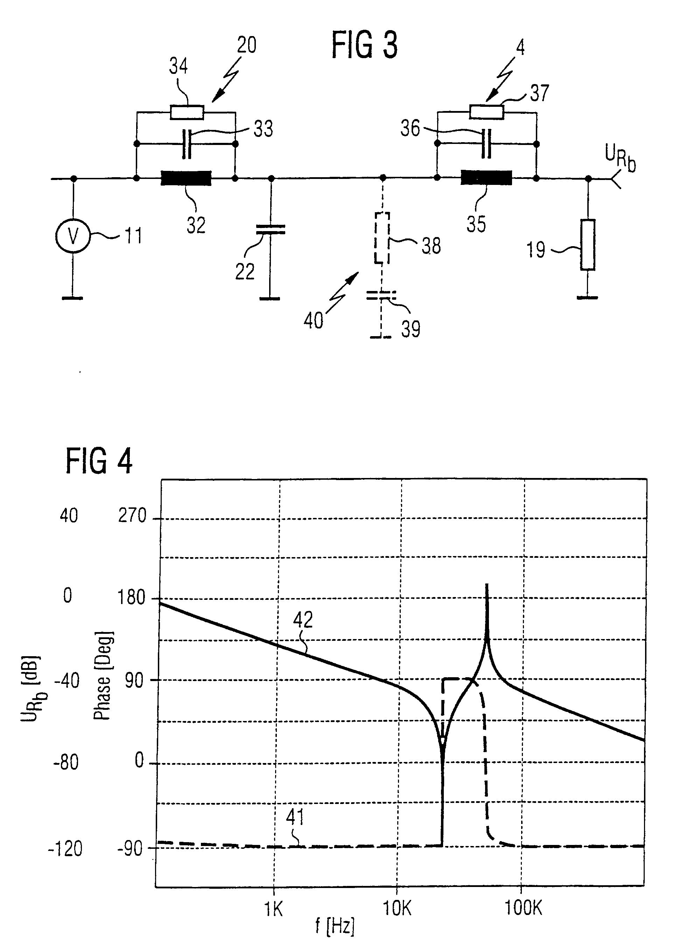

Dieser Sachverhalt wird nun näher anhand der Figuren 3 und 4 erläutert.

Figur 3 zeigt ein Ersatzschaltbild für die aus den Tiefpaßfiltern 17 und 18, dem Abschlußwiderstand 19 und der Sekundärwicklung 4 gebildete Brückenschaltung. Dabei ist die Spule 20 des Tiefpaßfilters 17 durch eine Filterinduktivität 32, eine Filterkapazität 33 und einen Filterwiderstand 34 dargestellt. Entsprechend ist die Sekundärwicklung 4 durch eine Wicklungsinduktivität 35, eine Wicklungskapazität 36 und einen Wicklungswiderstand 37 dargestellt. In Figur 3 gestrichelt eingezeichnet ist ferner ein von einem Widerstand 38 und einer Kapazität 39 gebildetes RC-Glied 40, auf das nachfolgend näher eingegangen wird.

In Figur 4 ist die Phase 41 und die Spannungsamplitude 42 der Meßspannung $U_{Rb}$ über dem Abschlußwiderstand 19 in Abhängigkeit von der Frequenz aufgetragen. Der erste Phasensprung um +180° wird durch die Wicklungskapazität 36 zusammen mit der Wicklungsinduktivität 35 erzeugt und ist von untergeordneter Bedeutung. Der zweite Phasensprung um -180° wird durch das Tiefpaßfilter 17 bewirkt und erzeugt auf der Resonanzfrequenz eine Amplitudenüberhöhung, auf der der Stromsensor 1 schwingen kann.

Für die Simulation wurden folgende Werte verwendet:

Die Filterinduktivität 32, die Filterkapazität 33 und der Filterwiderstand 34 wurden jeweils auf die Werte 220 μH, 10 pF und 0,5 Ohm gesetzt. Für die Wicklungsinduktivität 35, die Wicklungskapazität 36 und den Wicklungswiderstand 37 wurden schließlich die Werte 1 H, 50 pF und 40 Ohm gewählt.

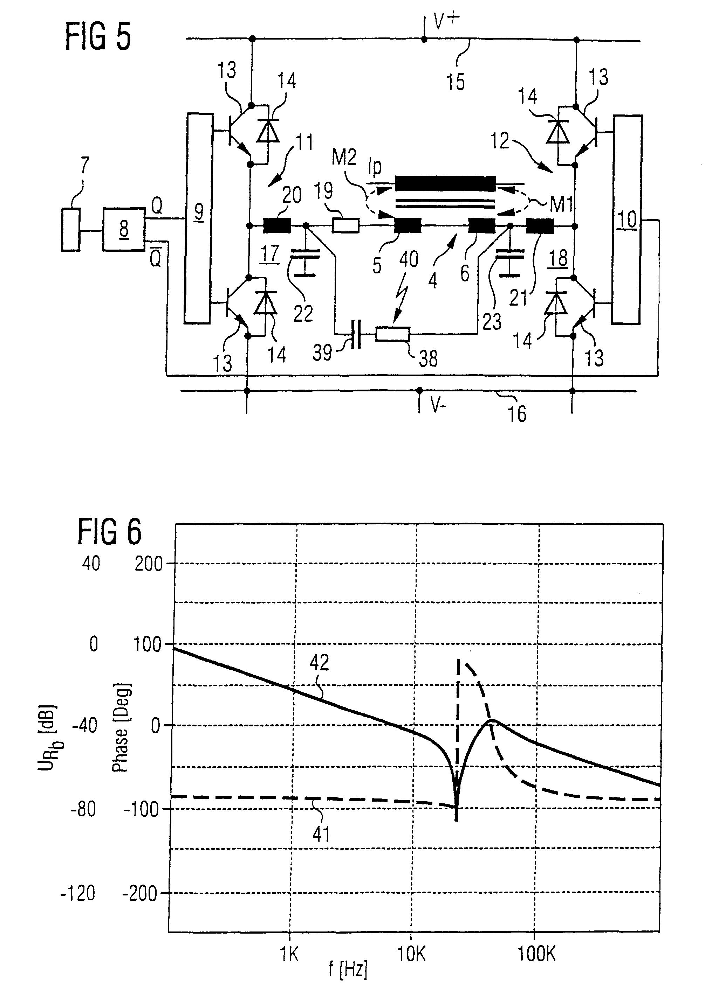

In Figur 5 ist die Resonanzüberhöhung beim zweiten Phasensprung durch das in Figur 3 gestrichelt eingezeichnete RC-Glied 40 gedämpft worden. Typische Werte für den Widerstand 38 und die Kapazität 39 sind 65 Ohm und 200 nF. Wie aus Figur 6 hervorgeht, wird durch das zusätzliche RC-Glied 40 die Güte der Resonanz verringert und damit die Amplitudenüberhöhung beim zweiten Phasensprung reduziert, so daß die 0 dB-Linie nicht mehr erreicht wird. Demzufolge treten in diesem Fall keine Schwingungen mehr auf.

Bei einem abgewandelten, nicht beanspruchten Stromsensor wird die Reduzierung der Resonanzüberhöhung durch einen zum Tiefpaßfilter 17 und 18 parallel geschalteten Widerstand bewirkt. Dieser parallel geschaltete Widerstand kann ebenfalls den Stromsensor 1 stabilisieren. Aber dafür würden die Filtereigenschaften der Tiefpaßfilter 17 und 18 verschlechtert werden.

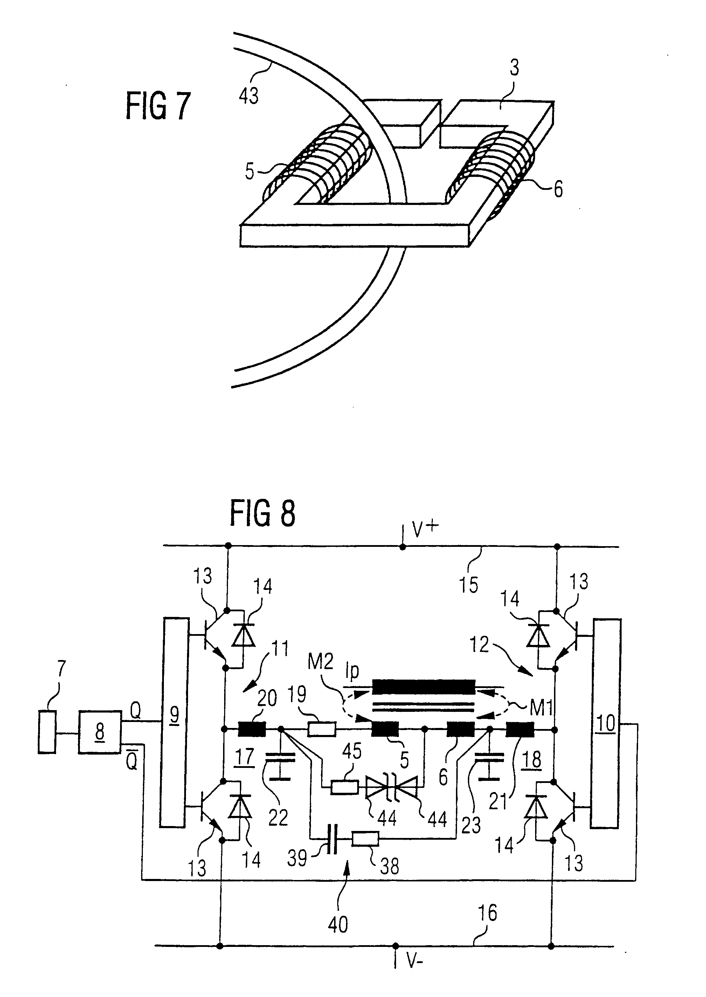

Ein weiteres Problem im Zusammenhang mit hohen Frequenzen des Primärstroms $I_p$ ist die Möglichkeit schneller Transienten des Primärstroms $I_p$. Dies ist insbesondere dann von Bedeutung, wenn die Sekundärwicklung 4 in beispielsweise die beiden Sekundärspulen 5 und 6 aufgeteilt ist. Üblicherweise ist die magnetische Kopplung zwischen der Primärwicklung 2 und den Sekundärspulen 5 und 6 aufgrund des mechanischen Aufbaus des Stromsensors 1 und der Anordnung der Primärwicklung 2 bezüglich der Sekundärspulen 5 und 6 unterschiedlich. In Figur 7 ist ein derartiger Fall dargestellt. In diesem Fall ist die Primärwicklung 2 ein drahtförmiger Leiter 43, der im Bogen durch die innere Öffnung des ringförmigen Magnetkerns 3 geführt ist. In dem in Figur 7 dargestellten Fall koppelt der drahtförmige Leiter 43 besser mit der Sekundärspule 5 als mit der Sekundärspule 6.

Dies hat zur Folge, daß bei einer schnellen Transiente des Primärstroms $I_p$, d. h. bei großen $dI_p/dt$ am Mittelpunkt zwischen den beiden Sekundärspulen 5 und 6 eine außerordentlich hohe Spannung auftritt. Dies kommt daher, daß beim Stromanstieg durch die unterschiedliche magnetische Kopplung M1 und M2 in den Sekundärspulen 5 und 6 unterschiedliche Sekundärströme angeregt werden. Da die Sekundärspule 5 und die Sekundärspule 6 in Reihe geschaltet sind, sind unterschiedliche Sekundärströme nur dann möglich, wenn an der Verbindung zwischen beiden Sekundärspulen 5 und 6 eine Überspannung erzeugt wird. Diese Überspannung kann leicht mehrere Kilovolt erreichen und führt zumindest zum Durchschlag der Wicklungsisolation der Sekundärspulen 5 und 6. Es ist deshalb wichtig, diese Überspannungen zu begrenzen.

Die Begrenzung der Überspannung ist bei dem in Figur 8 dargestellten Ausführungsbeispiel durch ein paar in Reihe geschaltete, in Gegenrichtung gepolte Zenerdioden 44 bewerkstelligt, die zusammen mit einem Ohmschen Widerstand 45 parallel zum Abschlußwiderstand 19 und zur Sekundärspule 6 geschaltet sind. Typischerweise liegt die Durchbruchspannung der Zenerdiode 44 bei 390 V. Damit die Begrenzungsschaltung bei niedrigem $dI_p/dt$ nicht wirksam wird, ist es von vorteil, wenn die Durchbruchsspannungen der Zenerdioden 44 möglichst hoch gewählt werden. Durch diese Begrenzungschaltung fließen bei Überspannungen über den Abschlußwiderstand 19 zusätzliche Ströme. Das Meßergebnis am Abschlußwiderstand 19 wird dadurch geringfügig beeinflußt. Allerdings geschieht dies nur bei hohen $dI_p/dt$ von beispielsweise über 100 A/µs. Solch schnelle Transienten treten im allgemeinen jedoch nur bei Kurzschlußströmen auf. In diesen Fällen ist jedoch keine hohe Genauigkeit bei der Messung des Primärstroms $I_p$ erforderlich.

Durch den Ohmschen Widerstand 45 wird die Überspannung weniger hart begrenzt. Bei einem Wert für den Ohmschen Widerstand von 1 kOhm wird die Zeitdauer der Überspannung auf 10 µs begrenzt.

Zweckmäßigerweise wird die Begrenzungsschaltung über diejenige der beiden Sekundärspulen 5 und 6 gelegt, die am stärksten an die Primärwicklung 2 gekoppelt ist. Es ist jedoch auch möglich, zusätzlich zu der in Figur 8 dargestellten Begrenzungsschaltung eine weitere entsprechende Begrenzungsschaltung über die Sekundärspule 6 vorzusehen. In gleicher Weise ist es möglich, den Widerstand 45 nicht mit dem Tiefpaßfilter 17, sondern mit Masse zu verbinden. Bei dieser Lösung fließen die Begrenzungsströme jedoch nicht über den Abschlußwiderstand 19 und werden deshalb nicht erfaßt.

Abschließend sei angemerkt, daß die hier vorgestellten Prinzipen und Maßnahmen auch für Stromsensoren mit nur einer Treiberendstufe gelten. Beispielsweise ist es möglich, bei den in den Figuren 5 und 8 dargestellten Ausführungsbeispielen die Gegentaktendstufe 11 sowie das Tiefpaßfilter 17 entfallen zu lassen und ein Ende des Abschlußwiderstands 19 mit Masse zu verbinden.

**Patentansprüche**

1. Stromsensor nach dem Kompensationsprinzip mit einer von einem zu messenden Strom durchflossenen Primärwicklung (2), die ein Magnetfeld erzeugt,
   einer von einem pulsweitenmodulierten Kompensationsstrom durchflossenen Sekundärwicklung (4), die ein das Magnetfeld der Primärwicklung kompensierendes Magnetfeld erzeugt, wobei Primärwicklung und Sekundärwicklung zusammen einen Wandler mit bestimmter Wandlergrenzfrequenz bilden,
   einem Abschlußwiderstand (19), der in Reihe zur Sekundärwicklung geschaltet ist,
   Sensormitteln (7), die dem resultierenden Magnetfeld von Primärspule und Sekundärspule ausgesetzt sind,
   einer Treiberschaltung (8 bis 12), die eingangsseitig den Sensormitteln (7) nachgeschaltet ist und die ausgangsseitig über den Abschlußwiderstand (19) die Sekundärwicklung (4) mit dem Kompensationsstrom speist, wobei der Kompensationsstrom eine Taktfrequenz oberhalb der Wandlergrenzfrequenz (25) aufweist und
   einer Tiefpaßfilteranordnung (17, 18) zur Glättung des pulsweitenmodulierten Kompensationsstromes, die der Treiberschaltung (8 bis 12) nachgeschaltet ist, Induktivitäten (20, 21) und Kapazitäten (22, 23) umfaßt, eine Filtergrenzfrequenz oberhalb der Wandlergrenzfrequenz (25) des Wandlers und unterhalb der Taktfrequenz (29) der Treiberschaltung besitzt sowie eine Resonanzüberhöhung aufweist, wobei
   die Resonanzüberhöhung der Tiefpaßfilteranordnung (17, 18) durch ein parallel zu Sekundärwicklung (4) und Abschlußwiderstand (19) geschaltetes RC-Glied (40) gedämpft wird.

2. Stromsensor nach Anspruch 1, bei dem die Sekundärwicklung (4) in eine Vielzahl von Sekundärspulen (5, 6) unterteilt ist, wobei zwischen den Sekundärspulen (5, 6) auftretende Überspannungen durch Begrenzungsmittel (44, 45) begrenzt werden.

3. Stromsensor nach Anspruch 2, bei dem die Begrenzungsmittel in Reihe geschaltete, gegensätzlich gepolte Zenerdioden (44) sind, die parallel zu den Sekundärspulen (5, 6) geschaltet sind.

4. Stromsensor nach einem der Ansprüche 1 bis 3 , bei dem die Treiberschaltung wenigstens eine Gegentaktendstufe (11, 12) aufweist.

5. Stromsensor nach Anspruch 4 , bei dem der Abschlußwiderstand (19) und die Sekundärwicklung (4) in Brückenschaltung zwischen zwei Gegentaktendstufen (11, 12) geschaltet sind.

**Claims**

1. Current sensor operating in accordance with the principle of compensation, comprising a primary winding (2) through which a current to be measured flows and which generates a magnetic field, a secondary winding (4) through which a pulse-width-modulated compensating current flows and which generates a magnetic field compensating for the magnetic field of the primary winding, the primary winding and the secondary winding together forming a transformer with a specific critical frequency, a terminating resistor (19) connected in series with the secondary winding, sensor means (7) exposed to the resulting magnetic field of the primary coil and the secondary coil, a driver circuit (8 to 12) connected downstream of the sensor means (7) on the input side and supplying the compensating current to the secondary winding (4) via the terminating resistor (19) on the output side, the compensating current displaying a pulse frequency above the critical frequency (25) of the transformer, and a low-pass filter arrangement (17, 18) for smoothing the pulse-width-modulated compensating current, connected downstream of the driver circuit (8 to 12), including inductors (20, 21) and capacitors (22, 23), having a critical frequency above the critical frequency (25) of the transformer and below the pulse frequency (29) of the driver circuit and displaying increased resonance, the increased resonance of the low-pass filter arrangement (17, 18) being damped by an RC element (40) connected in parallel with the secondary winding (4) and the terminating resistor (19).

2. Current sensor according to claim 1, in which the secondary winding (4) is divided into a plurality of secondary coils (5, 6), overvoltage occurring between the secondary coils (5, 6) being limited by limiting means (44, 45).

3. Current sensor according to claim 2, in which the limiting means are series-connected, oppositely poled Zener diodes (44) connected in parallel with the secondary coils (5, 6).

4. Current sensor according to one of claims 1 to 3, in which the driver circuit has at least one push-pull output stage (11, 12).

5. Current sensor according to claim 4, in which the terminating resistor (19) and the secondary winding (4) are bridge-connected between two push-pull output stages (11,12).

## Revendications

1. Capteur de courant fonctionnant selon le principe de la compensation, muni d'un enroulement primaire (2) parcouru par un courant à mesurer et générant un champ magnétique, d'un enroulement secondaire (4) parcouru par un courant de compensation à modulation en largeur d'impulsions, générant un champ magnétique compensant le champ magnétique de l'enroulement primaire, l'enroulement primaire et l'enroulement secondaire formant un transducteur avec une fréquence seuil de transducteur définie, d'une résistance de terminaison (19) montée en série sur l'enroulement secondaire, de capteurs (7) soumis au champ magnétique résultant de la bobine primaire et de la bobine secondaire, d'un circuit d'excitation (8 à 12) placé en aval du côté entrée des capteurs (7) et qui alimente l'enroulement secondaire (4) en courant de compensation du côté sortie à l'aide de la résistance de terminaison (19), le courant de compensation présentant une cadence supérieure à la fréquence seuil du transducteur (25), et

d'un dispositif de filtre passe-bas (17, 18) pour lisser le courant de compensation à modulation d'impulsions en largeur placé en aval du circuit d'excitation (8 à 12), comprenant des inductances (20, 21) et des capacités (22, 23), disposant d'une fréquence seuil de filtre supérieure à la fréquence seuil du transducteur (25) du transducteur et inférieure à la cadence (29) du circuit d'excitation, et qui présente une amplification de résonance, l'amplification de résonance du dispositif de filtre passe-bas (17, 18) étant amortie par un circuit RC (40) monté en parallèle de l'enroulement secondaire (4) et d'une résistance de terminaison (19).

2. Capteur de courant selon la revendication 1, **caractérisé en ce que** l'enroulement secondaire (4) est divisé en plusieurs bobines secondaires (5, 6), des surtensions se produisant entre les bobines secondaires (5, 6) étant limitées par des moyens de limitation (44, 45).

3. Capteur de courant selon la revendication 2, **caractérisé en ce que** les moyens de limitation sont des diodes de Zener à polarisation opposée et montées en série, parallèlement aux bobines secondaires (5, 6).

4. Capteur de courant selon l'une des revendications 1 à 3, **caractérisé en ce que** le circuit d'excitation présente au moins un étage final symétrique (11, 12).

5. Capteur de courant selon la revendication 4, **caractérisé en ce que** la résistance de terminaison (19) et l'enroulement secondaire (4) sont montés en pont entre deux étages finaux symétriques (11, 12).

FIG 1

FIG 2

7

# FIG 3

# FIG 4

## FIG 5

## FIG 6

# FIG 7

# FIG 8